# EUROPEAN PATENT SPECIFICATION

(11) **EP 3 398 209 B1**
(45) Date of publication and mention of the grant of the patent: **06.11.2019**
(21) Application number: 16826618.7
(22) Date of filing: 27.12.2016
(51) Int. Cl.: H01L 31/05

(54) **ADVANCED INTERCONNECT METHOD FOR PHOTOVOLTAIC STRINGS AND MODULES**
ERWEITERTES VERBINDUNGSVERFAHREN FÜR PV-STRINGS UND PV-MODULE
PROCÉDÉ D'INTERCONNEXION AVANCÉE POUR CHAÎNES ET MODULES PHOTOVOLTAÏQUES

(30) Priority: 30.12.2015 US 201562272950 P
(43) Date of publication of application: 07.11.2018
(73) Proprietor: Corner Star Limited, Kowloon, Hong Kong (HK)
(72) Inventor: NADIMPALLY, Bhavananda Reddy, Maryland Heights Missouri 63043 (US); BEARDEN, Jeanette Lee, Maryland Heights Missouri 63043 (US); NOVOA PEREZ, Fernando Daniel, Maryland Heights Missouri 63043 (US); DESHPANDE, Aditya Janardan, Maryland Heights Missouri 63043 (US)
(74) Representative: Parchmann, Stefanie
(86) International application number: PCT/US2016/068720
(87) International publication number: WO 2017/117136

(56) References cited:
- WO-A1-2013/020590
- US-A- 4 617 420
- US-A1- 2003 121 228
- US-A1- 2010 218 799

## Description

### FIELD

This disclosure relates generally to photovoltaic (PV) modules and, more specifically, advanced interconnect systems and methods for producing strings of shingled PV cells for use in PV modules.

### BACKGROUND

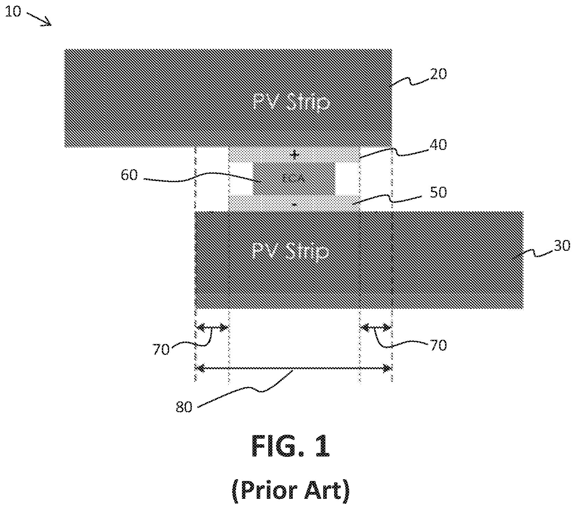

Some known photovoltaic (PV) strings are constructed by shingling cells using PV cell segments cut from full size PV cells. Constructing PV modules using strings of shingled cells reduces electrical and optical losses compared to the conventional solar modules in which full size cells are soldered using copper ribbons on silver busbars. FIG. 1 is a side view of a typical arrangement 10 for producing a string of shingled cells. A PV cell segment 20 is positioned above a PV cell segment 30. The PV cell segment 20 has a rear electrode 40 that is aligned with a front electrode 50 of the PV cell segment 30. An electrically conductive adhesive (ECA) 60 is disposed between the electrodes 40 and 50. In some systems, a solder paste is used in place of the ECA 60. As used herein, the term "ECA" includes electrically conductive adhesive, solder, solder paste, conductive tapes, and any other material for use electrically and mechanically connecting electrodes PV cell segments. The effective resistance between PV cell segments 20 and 30 is the sum of the contact resistance between electrode 40 and ECA 60, bulk resistance of ECA 60, and contact resistance between electrode 50 and ECA. All known PV strings constructed using shingled PV cells include some type of foreign material (e.g., ECA) between shingled cells to provide electrical contact and mechanical attachment between the cells.

Shingling of cells with ECA requires very tight control over the dispensing parameters. Slight deviations can cause the segments to short, resulting in total loss of power for the shorted segment. Further, the properties of the particular ECA typically constrain the dimensions of the overlap between two PV cell segments. For example, the lateral shear on the cured ECA and the amount of ECA that comes out from between the contacts requires a certain minimum overlap between two cells connected by the ECA. Reducing overlap between cells improves module output and reduces Cell-to-Module (CTM) losses. In the example arrangement 10, the contacts 40 and 50 are about 1.0 millimeters (mm) wide. Gaps 70 on either side of the contacts 40 and 50 are needed because of the ECA 60. Gaps 70 are each about 0.25 mm wide, resulting in a total overlap 80 of about 1.5 mm. Thus, in the arrangement 10, a section of the segment 30 that is 1.5 mm wide and spans the entire width of the segment is covered by segment 20, receives no sunlight, and produces no electricity.

Moreover, installed PV modules are exposed to sun, wind, snow, rain, ice, and the like. PV modules need to be designed to withstand the resulting cycles of temperature changes, mechanical loading and unloading, foreign object impacts, and other stresses produced in the field. Specifically, PV modules need to absorb the applied stresses and maintain electrical conductivity between cells, or PV cell segments. It is unclear whether ECAs will be able to maintain suitable connection and conductivity, because aging of ECAs is not a well-studied field.

US 2003/121228 A1 discloses a dendritic web solar cell shingled array comprising at least two dendritic web solar cells. A first cell overlaps a portion of a second cell such that a back contact of the first cells interconnects with a top contact of the second cell.

US 2010/218799 A1 discloses a process for series connection of two photovoltaic cells in series, comprising following stages: predisposing a first photovoltaic cell and a second photovoltaic cell, both of a type comprising a photosensitive semiconductor layer provided with front contacts and back contacts arranged on opposite surfaces of the cell; partially superposing the two photovoltaic cells, causing at least a partial superposing of the back contact of the first photovoltaic cell on the front contact of the second photovoltaic cell and consequently establishing an electrical contact between the back contact and the front contact.

WO 2013/020590 A1 discloses a connection technique between solar cells which encompasses an overlapping arrangement of adjacent PV cells.

This Background section is intended to introduce the reader to various aspects of the art that may be related to various aspects of the present disclosure, which are described and/or claimed below. This discussion is believed to be helpful in providing the reader with background information to facilitate better understanding of the various aspects of the present disclosure. Accordingly, it should be understood that these statements are to be read in this light, and not as admissions of prior art.

### BRIEF DESCRIPTION

According to one aspect of this disclosure, a photovoltaic (PV) module includes a front layer, a rear layer, and a string of series connected PV cell segments laminated between the front layer and the rear layer. Each PV cell segment has a front surface including a front electrode and a rear surface including a rear electrode. Adjacent PV cell segments are overlapped by an overlap amount with the front electrode of one of the adjacent PV cell segments disposed under and directly contacting the rear electrode of the other of the adjacent PV cell segments, without foreign material therebetween, such as electrically conductive adhesive. At least one adhesive strip is attached to the bottom surfaces of a pair of adjacent PV cell segments.

Another aspect of this disclosure is a method of making a photovoltaic (PV) string of PV cell segments. Each PV cell segment has a front surface with a front electrode and a rear surface with a rear electrode. The method includes positioning a first PV cell segment and positioning a second PV cell segment overlapping a portion of the first PV cell segment. The second PV cell segment is positioned such that the front electrode of one of the first and second PV cell segments directly contacts with the rear electrode of the other of the first and second PV cell segments, without foreign material therebetween, such as electrically conductive adhesive. A first adhesive strip is applied across the rear surfaces of the first and second PV cell segments. A third PV cell segment is positioned overlapping a portion of the second PV cell segment, the third PV cell segment being positioned such that the front electrode of one of the second and third PV cell segments is in direct contact with the rear electrode of the other of the second and third PV cell segments.

Various refinements exist of the features noted in relation to the above-mentioned aspects. Further features may also be incorporated in the above-mentioned aspects as well. These refinements and additional features may exist individually or in any combination. For instance, various features discussed below in relation to any of the illustrated embodiments may be incorporated into any of the above-described aspects, alone or in any combination.

### BRIEF DESCRIPTION OF THE DRAWINGS

FIG. 1 is a side view of a prior art arrangement used to produce a string of shingled PV cell segments.
FIG. 2 is a perspective view of an example photovoltaic (PV) module.
FIG. 3 is a cross-sectional view of the PV module shown in Fig. 1.
FIG. 4 is a top plan view of a PV cell for production of PV cell segments.
FIG. 5 is a top plan view of the PV cell shown in FIG. 4 after singulation.
FIG. 6 is an illustration of the process for assembling PV cell segments into a shingled PV cell string.
FIG 7. is a side view of two PV cell segments directly connected in a string.
FIG 8. is a top plan view of an assembled PV cell string of PV cell segments.
FIG 9. is a bottom plan view of the PV cell string shown in FIG. 8.
FIG 10. is a bottom plan view of another assembled PV cell string to the PV cell string shown in FIGS. 8 and 9.
FIG 11. is a side view of an assembly for stringing PV cell segments into PV cell strings.
FIGS. 12 and 13 are electroluminescence (EL) images captured during production of a string of PV cell segments on the assembly shown in FIG. 11.
FIG. 14 is a flowchart of a method for assembling PV modules without ECA.
FIG 15. is an EL image of a test panel of strings of PV cell segments without ECA.
FIG. 16 is a graph of the IV curve for the panel shown in FIG. 15.
FIG. 17 is a graph of the normalized resistance of panels of strings PV cell segment as a function of temperature and overlap.
FIG. 18 includes EL images of a panel of strings of PV cell segments without ECA before testing and after a 5400 Pa load test.
FIG. 19 is a graph of output current as a function of irradiance for a PV module using chamfered PV cell segments shingled without ECA.
FIG. 20 is a graph of output current as a function of irradiance for a PV module using rectangular PV cell segments shingled without ECA.
FIG. 21 is an EL image of a test panel of strings of HJT PV cell segments without ECA.
FIG. 22 is a graph of the IV curve for the panel shown in FIG. 21.
FIG. 23 is a flexible PV laminate constructed with forty-one PV cell segments shingled together without ECA between electrodes.
FIG. 24 is an image of the laminate shown in FIG. 23 deflected into an arcuate shape.

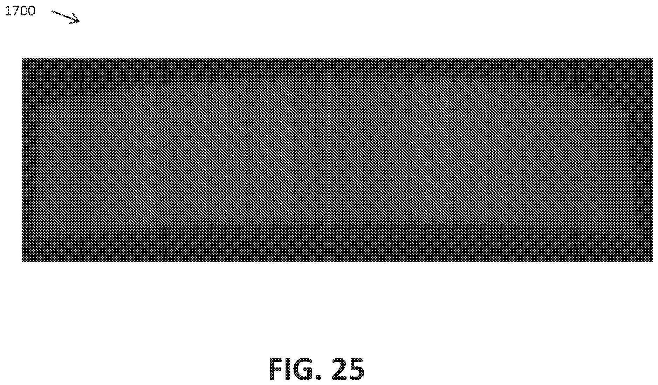

FIG. 25 is an EL image of the deflected laminate shown in FIG. 24.

Corresponding reference characters indicate corresponding parts throughout the several views of the drawings.

### DETAILED DESCRIPTION

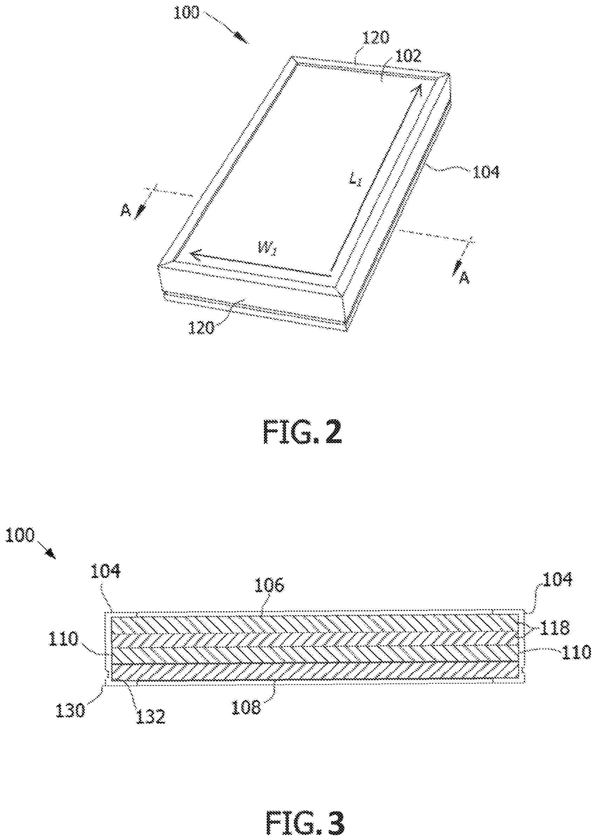

Referring initially to FIGS. 2 and 3, one embodiment of a photovoltaic (PV) module is indicated generally at 100. A perspective view of the PV module 100 is shown in Fig. 2. Fig. 3 is a cross-sectional view of the PV module 100 taken at line A-A as shown in Fig. 2. PV module 100 includes a laminate 102 and a frame 104 circumscribing the laminate 102.

The laminate 102 includes a top surface 106 (also referred to as a sun receiving side) and a bottom surface 108 (shown in FIG. 3). Edges 110 extend between the top surface 106 and the bottom surface 108. In this embodiment, the laminate 102 is rectangular shaped. In other embodiments, the laminate 102 may have any suitable shape. The laminate 102 has a width *W₁* and a length *L₁.*

As shown in FIG. 3, the laminate 102 has a laminate structure that includes several layers 118. The layers 118 may include, for example, glass layers, encapsulant, non-reflective layers, electrical connection layers, n-type silicon layers, p-type silicon layers, and/or backing layers. One or more of the layers 118 may also include strings of PV cells (not shown in FIGS. 2 and 3). In the example embodiment, the laminate 102 includes (from top surface 106 to bottom surface 108) a glass layer (also referred to as a front layer), a front side encapsulant layer, a layer of PV cell strings (which also includes encapsulant), a back side encapsulant layer, and a backsheet or glass layer (also referred to as a rear layer). In other embodiments, the laminate 102 may have more or fewer, including one, layers 118, may have different layers 118, and/or may have different types of layers 118. Moreover, the front layer and the rear layer may be materials other than glass, such as a plastic, another laminate, a film, and the like.

Each string of PV cells within laminate 102 includes multiple PV cells connected in series. In the example embodiment, each string of PV cells includes multiple PV cell segments connected in series. The strings of PV cells within laminate 102 are electrically connected to each other in series, parallel, or a combination of series and parallel connections to produce a desired output voltage and current. In embodiments with multiple PV cell strings, the PV cell strings are typically coupled to each other within a junction box. Alternatively, the PV cell strings may be coupled together within the laminate 102.

As shown in FIG. 3, the frame 104 circumscribes laminate 102. The frame 104 is coupled to the laminate 102, as best shown in FIG. 2. The frame 104 assists in protecting the edges 110 of the laminate 102 and provides additional rigidity to the PV module 100. In this embodiment, the frame 104 is constructed of four frame members 120. In other embodiments the frame 104 may include more or fewer frame members 120. The example frame 104 includes an outer surface 130 spaced apart from the laminate 102 and an inner surface 132 adjacent the laminate 102. The outer surface 130 is spaced apart from and substantially parallel to the inner surface 132. In the example embodiment, the frame 104 is made of aluminum. More particularly, in some embodiments the frame 104 is made of 6000 series anodized aluminum. In other embodiments, the frame 104 may be made of any other suitable material providing sufficient rigidity including, for example, rolled or stamped stainless steel, plastic, or carbon fiber.

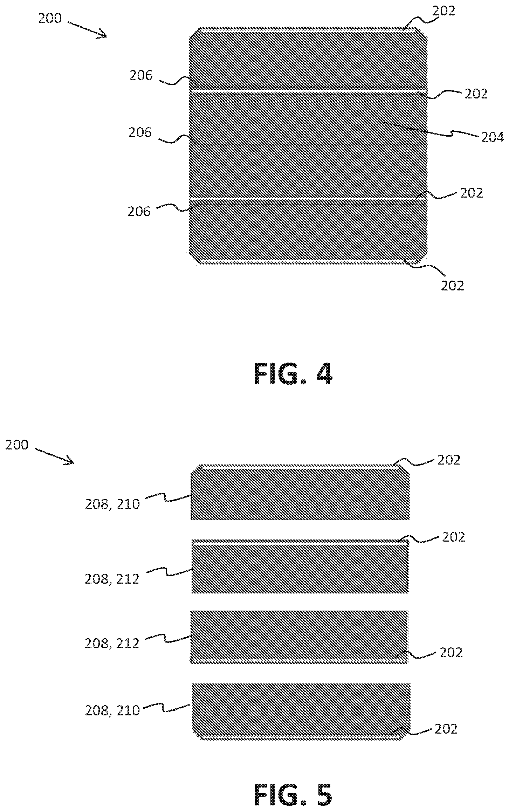

FIG. 4 is a top plan view of an example PV cell 200 for production of PV cell segments. The PV cell 200 includes busbars 202 disposed on the top surface of a silicon substrate 204. The busbars 202 are sometimes referred to as front electrodes. The rear surface (not shown) of the silicon substrate includes one or more rear electrodes. The silicon substrate 204 may be a monocrystalline silicon substrate or a polycrystalline substrate. The PV cell 200 includes fingers (not shown) disposed on the silicon substrate 204 substantially perpendicular to the busbars 202. The PV cell 200 has three cut lines 206 at which PV cell 200 will be separated into PV cell segments. The fingers disposed on substrate 204 do not extend over the cut lines 206. Alternatively, the fingers extend over one or more of the cut lines 206. With four busbars 202 and three cut lines 206, the illustrated PV cell 200 is configured for singulation into four PV cell segments. Alternatively, the PV cell 200 may be configured for singulation into more or fewer PV cell segments. For example, in various embodiments, the PV cell 200 is configured for singulation into two PV cell segments, three PV cell segments, or six PV cell segments.

FIG. 5 is a top plan view of the PV cell 200 after singulation. The PV cell 200 has been separated at the cut lines 206 into four PV cell segments 208 (sometimes referred to as cells). The PV cell 200 may be separated into PV cell segments 208 by cutting at the cut lines 206, such as with a saw or a laser cutter, by ablating or etching at the cut lines and snapping the substrate 204 at the etching, or by any other suitable method dividing the substrate 204. Because the silicon substrate 204 of the PV cell 200 has a pseudo-square shape, the two PV cell segments 208 from the outside edges of the PV cell 200 are chamfered segments 210. The PV cell segments 208 singulated from the interior portion of the PV cell 200 are rectangular segments 212.

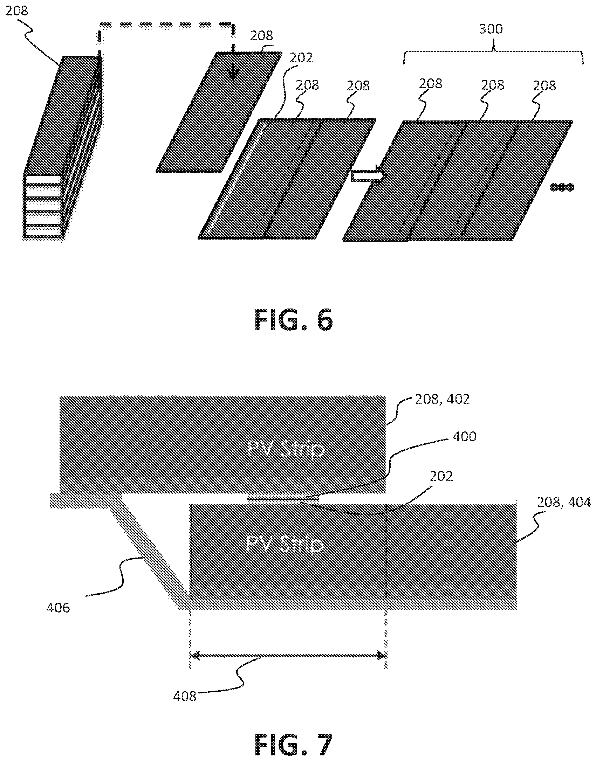

FIG. 6 is an illustration of the process for assembling PV cell segments 208 into a shingled PV cell string 300. The PV cell segments 208 are overlapped with the front electrode (i.e., busbar 202) of the lower PV cell segment 208 directly contacting the rear electrode (not shown in FIG. 6) of PV cell segment 208 positioned above it. As used herein, direct contact, direct connection, directly contacting, directly connected, and the like describe physical contact between two components (such as electrodes) without a foreign material between the components at the contact point. No electrically conductive adhesive (ECA) or foreign material is used to mechanically and/or electrically connect the PV cell segments 208 to each other. The overlap between adjacent PV cell segments is between 0.001 mm and 156 mm.

FIG. 7 is a side view of two PV cell segments 208 in a string, such as PV cell string 300. A rear electrode 400 of upper PV cell segment 402 directly contacts the front electrode busbar 202 of the lower PV cell segment 404 without any ECA between them. Insulating adhesive strips 406 are attached to the rear sides of the upper and lower PV cell segments 402 and 404 to hold them together prior to and during lamination into a PV laminate. Although only one adhesive strip 406 is visible in FIG. 7, two or more adhesive strips 406 are typically attached between each two shingled PV cell segments 208. The adhesive strip 406 is any suitable insulating strip of adhesive material, such as an adhesive tape or adhesive sheets. In some embodiments, the adhesive strips 406 are tape made from a polyimide film with a silicon adhesive, such as a Kapton® tape. In some embodiments, adhesive strips 406 are made from PET or cellulose based adhesive tapes.

In laminated PV modules the encapsulant (such as EVA, PVB, TPU, polyolefin, silicones, EPDM and ionomers) can expand and contract significantly more than the PV cells segments with changing temperatures. This may result in the PV cell segments separating over time, resulting in open circuits. Adhesive strips 406 help compensate for this differential expansion and help ensure that the cell segments don't slide away from each other.

Because there is no ECA between the segments 402 and 404, they can be positioned with a smaller overlap 408 than similar cells using ECA. The overlap 408 is typically less than about 1.5 mm. In various embodiments, the overlap 408 is less than about 1.0 mm, less than about 0.5 mm, or less than about 0.1 mm. In particular embodiments, the overlap 408 is about 0.9 mm, 0.2 mm, or 0.1 mm. The minimum overlap 408 is determined at least in part by the dimensions of the front and rear electrodes of the PV cell segments, the amount of friction between the adjacent front and rear electrodes 400 and 202, the strength of the adhesive strips 406, the manufacturing tolerances, and the like. If the overlap 408 is too small, contact between front and rear electrodes 404 and 202 may be compromised, resulting in an increase of resistance between the adjacent PV cell segments 208.

The effective resistance between PV cell segments 402 and 404 is simply the contact resistance between electrode busbar 202 and rear electrode 400.

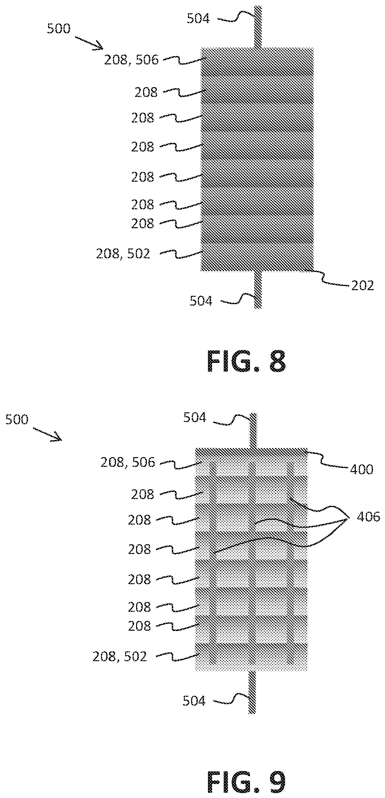

FIGS. 8-10 illustrate embodiments of PV cell strings assembled from PV cell segments as described above.

FIG. 8 is a top plan view of an assembled PV cell string 500 made from PV cell segments 208 as described above. FIG. 9 is a bottom plan view of the PV cell string 500. The PV cell segments 208 are shingled with their front and rear contacts directly connected to each other. The busbar 202 of the uppermost PV cell segment 502 is connected to a conductor 504. The rear electrode 400 of the rearmost PV cell segment 506 is also connected to a conductor 504. Conductors 504 are used to connect the string 500 to other strings 500, to connect the string 500 to an output of a module incorporating the string, and/or to connect the string 500 to any other external components, such as bypass diode assemblies, power converters, maximum power point trackers, and the like.

As shown in FIG 9, three adhesive strips 406 are attached to the rear side of the PV cell string 500 to hold the PV cell segments 208 in position with respect to each other. Each of the three adhesive strips 406 extends across all of the PV cell segments 208 in the string 500. In other embodiments, more or fewer than three adhesive strips 406 may be used. The number of adhesive strips 406 used may be varied, among other reasons, based on the width of the adhesive strips (with wider strips resulting in fewer strips 406 being needed), and/or the strength of the adhesive on the adhesive strips (with stronger adhesive resulting in fewer strips 406 being needed).

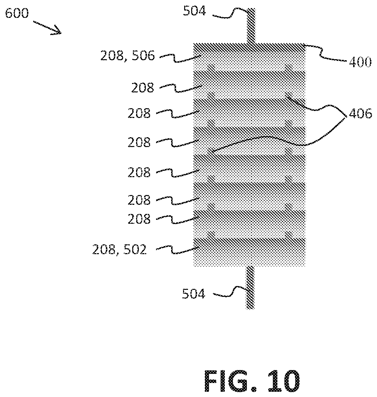

FIG. 10 is a bottom plan view of another assembled PV cell string 600 similar to PV cell string 500. The top (not shown) of string 600 is substantially the same as the top of string 500 shown in FIG. 8. The PV cell segments 308 of string 600 are connected by adhesive strips 406 that are not connected to all of the PV cell segments 208 in the string. Rather, each adhesive strip is connected to two adjacent/shingled PV cell segments 208. Although the PV cell string 600 includes two adhesive strips 406 attached to each adjacent/shingled pair of PV cell segments 208, other embodiments include more or fewer adhesive strips 406 per pair.

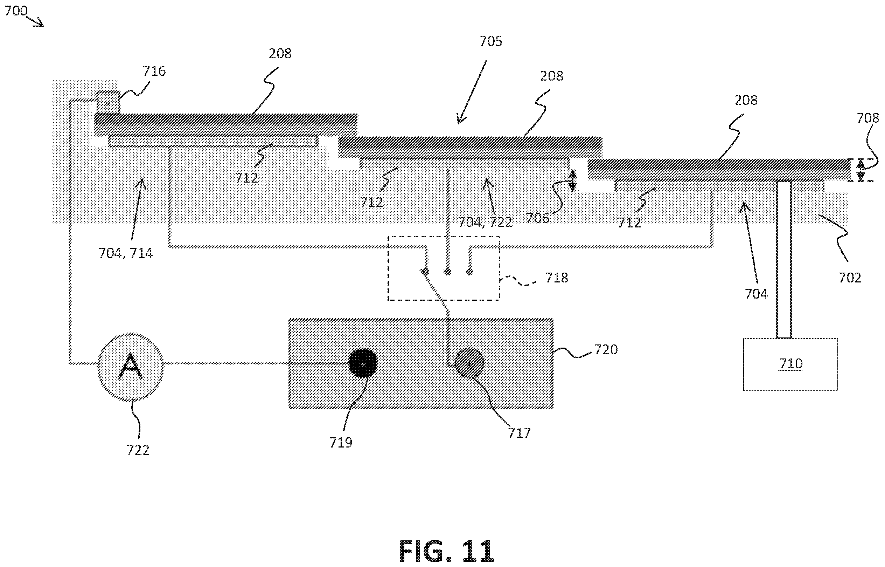

FIG. 11 is a side view of an assembly 700 for stringing PV cell segments 208 into PV cell strings. Assembly 700 includes an insulated base 702 including segment positions 704. Each segment position 704 is configured to receive and hold a PV cell segment 208. Although three segment positions 704 are illustrated, the assembly 700 includes as many segment positions 704 as are needed to build a string 705 of PV cell segments 208. The segment positions are vertically offset by a distance 706 substantially equal to a thickness 708 of the PV cell segments 208. A vacuum source 710 is used to apply vacuum pressure to hold the PV cell segments 208 in position on the base 702. Vacuum source 710 is connected to each segment position 704, although only illustrated connected to one segment position 704 for clarity of illustration.

The assembly 700 is configured to allow inline testing of the string 705 of PV cell segments 208. Each segment position 704 includes an electrically conductive test contact 712 that is configured to contact the rear electrode 400 of the PV cell segment 208 positioned in that segment position 704. The uppermost segment position 714 includes an upper contact 716 configured to contact the upper electrode/bus bar of the PV cell segment 208 positioned in segment position 714. The test contacts 712 are connected to a switch 718. Switch 718 and upper contact 716 are connected to first and second contacts 717 and 719 (respectively) of a test terminal 720. Switch 718 allows for selective coupling of one or more PV cell segments 208 to test terminal 720 to permit one or more PV cell segments 208 to be tested in position on the assembly 700. Thus, when the switch is connected as shown in FIG. 11, only the uppermost segment 714 is electrically connected to the test terminal 720. Selecting the middle position of switch 718 connects the middle segment 722 and the uppermost segment 714 to test terminal 714 in series. The rightmost position of switch 718 connects all three segments 208 to the test terminal 720 in series. In some embodiments, the test contacts 712 are also selectively coupled, such as via another switch, to contact 719 to allow testing of individual PV cell segments within the string 705.

An ammeter 722 is connected between upper contact 716 and test contact 719 to allow measurement of current through one or more PV cell segments 208 of the string 705. Electrical parameters of the string 705 and/or individual cell segments 208, such as open circuit voltage (Voc), short circuit current (Isc), maximum power current(Imp), maximum power voltage (Vmp), fill factor (FF), series resistance (Rs), shunt resistance (Rsh), power, efficiency, and the like, can be measured by attaching appropriate hardware to the test terminal 720. This allows defective and/or lower performing cell segments 208 to be easily detected and replaced. Reverse current at specified voltages may be applied to help determine which (if any) cell segments 208 are likely to cause failure in the field.

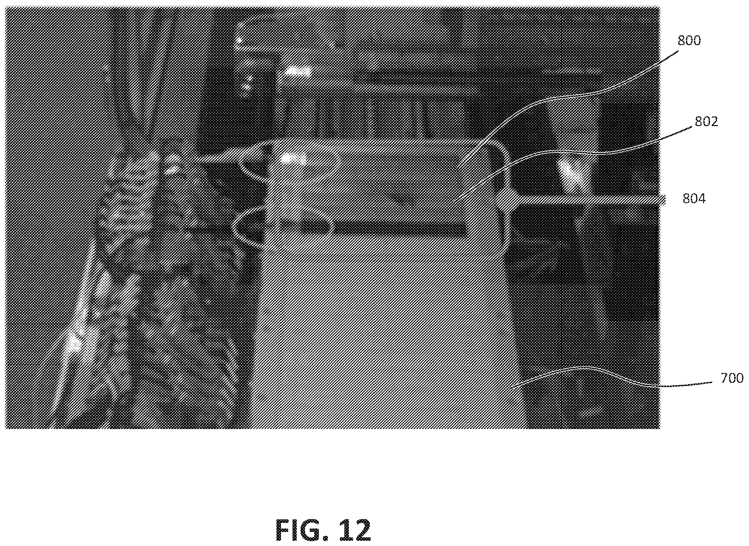

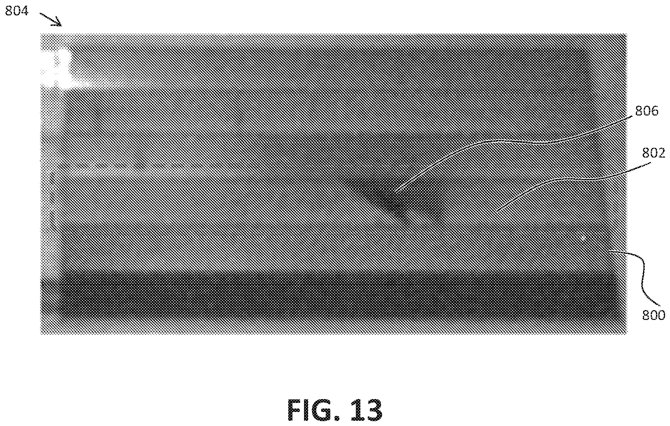

FIGS. 12 and 13 are electroluminescence (EL) images captured during production of a string 800 of PV cell segments 208 on the assembly 700. FIG. 13 is a close-up view of section 804 of FIG. 12. Defective PV cell segment 802 is clearly identifiable (by the dark patch 806) in the EL images. Although the entire string 800 can be tested on the assembly 700, because the PV cell segments 208 are not yet permanently bonded together, the defective PV cell segment 802 may be removed and replaced with a functional PV cell segment without significant difficulty.

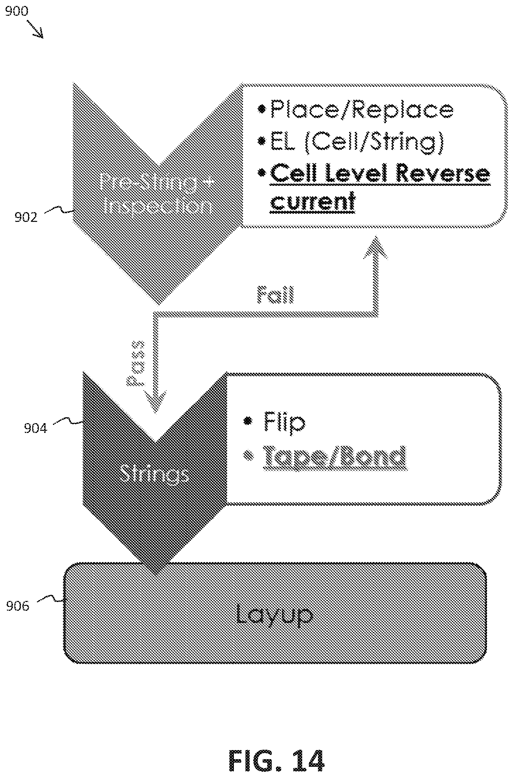

FIG. 14 is a flowchart 900 of a method for assembling PV modules without ECA as described herein. At 902, PV cell segments, such as PV cell segments 208, are placed in a stringing assembly, such as assembly 700, to produce a PV cell string. The individual PV cell segments and the string are subjected to testing while on the stringing assembly. In particular, EL imaging is performed to detect any defective cell segments in the string. The cell segments are also tested for reverse current. In some embodiments, additional or alternative tests may be performed. If any cell segments are identified as defective or substandard, the string fails and the defective cell segments are removed and replaced. Testing is performed again and the process repeats until the string passes the testing. In some embodiments, after the string passes the initial testing, additional tests are performed on the string to measure the characteristics of the assembled string.

After the string passes inspection, at 904, the string is turned over to expose the rear sides of the PV cell segments. Adhesive strips are applied to the rear surface of the segments to hold them in place.

At 906, the assembled and bonded string of PV cell segments proceeds to PV module layup, in which the string is incorporated, along with front glass, encapsulant, rear sheet, additional strings of PV cell segments, into a PV module layup to be laminated into a PV laminate.

Several PV panels were constructed and tested using the techniques described herein.

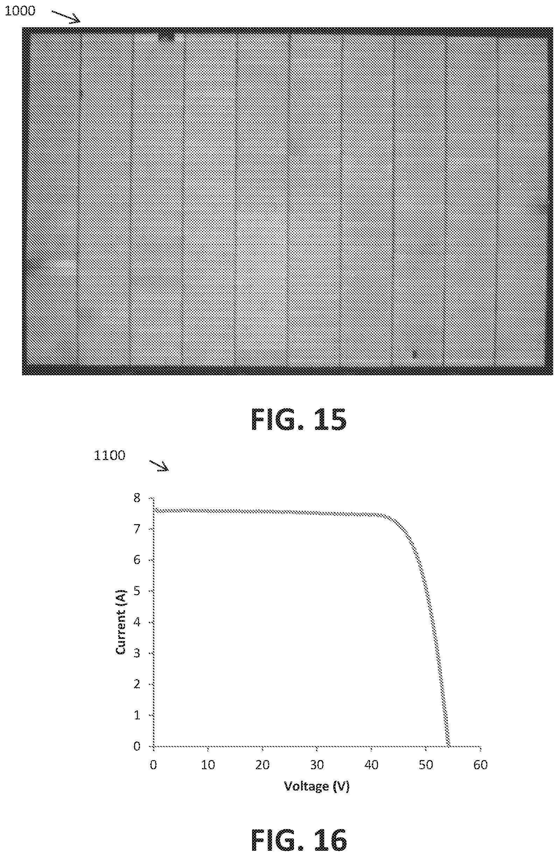

An EL image of a first test panel 1000 is shown in FIG. 15. Panel 1000 includes ten strings of PV cell segments laminated into a PV laminate. Although the strings extend in the direction of the width (i.e., in the direction W1 shown in FIG. 2) of the panel, the strings may alternatively extend in the direction of the length (i.e., in the direction L1 shown in FIG. 2) of the panel. Each string was constructed in the manner of PV cell string 600 (shown in FIG. 10). The PV cell segments were shingled with a 1.5 mm overlap and no ECA between electrodes. FIG. 16 is a graph 1100 of the IV curve for the panel 1000. The maximum power output of the panel 100 was 323.09 watts (W). A similar panel produce with ECA produced a maximum power output of about 322.67 W.

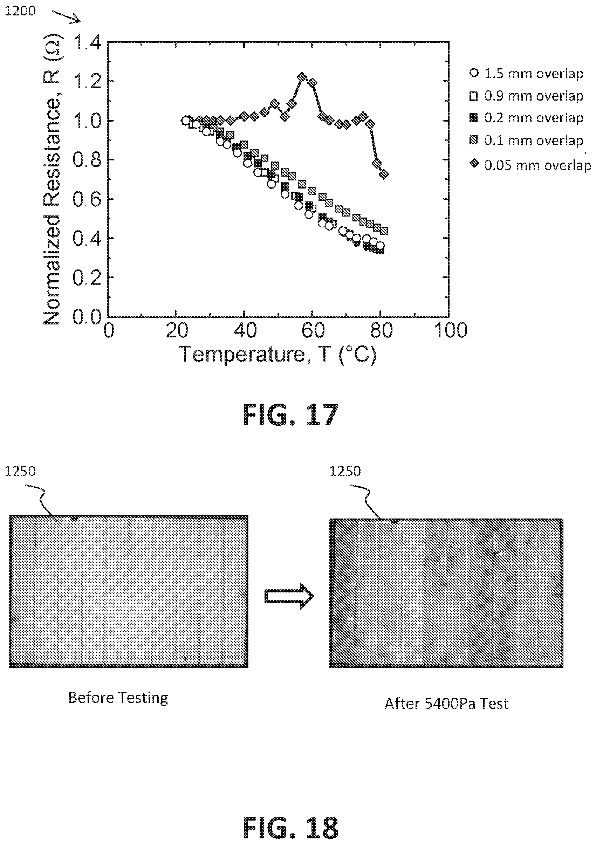

Several PV panels similar to panel 1000 were produced with strings of PV cell segments shingled with different amounts of overlap between PV cell segments. Specifically, additional panels were constructed with a 0.9 mm overlap, a 0.2 mm overlap, a 0.1 mm overlap, and a 0.05 mm overlap. All of these panels did not use ECA between electrodes of the segments and used two separate strips of adhesive for each pair of PV cell segments, similar to PV cell string 600 (shown in FIG. 10). FIG. 17 is a graph 1200 of the normalized resistance of the panels (in ohms) as a function of temperature.

Similarly constructed panels were subjected to mechanical load tests simulating wind and snow loads, followed by thermal cycling. During thermal cycling some of the PV cell segments moved out of place. This movement may have been possible due to the characteristics of the adhesive tape used to hold the shingled PV cell segments together and/or the configuration of placement of the adhesive strips. Despite the movement, the mechanical load test performance of the cells was very good. FIG. 18 shows EL images of a panel 1250 before testing and after a 5400 Pa load test. The results of the test are shown in Table 1:

**Table 1**

| | **MLT 0** | **MLT 5400 Front** | **Change** |
|---|---|---|---|
| P ₘₐₓ | 316.5 W | 315.4 W | -0.4% |
| FF | 76.5 | 76.0 | -0.7% |
| V_{OC} | 54.1 V | 54.2 V | 0.2% |
| I _{SC} | 7.6 A | 7.6 A | 0.1% |
| V_{MPP} | 44.4 V | 44.2 V | -0.3% |
| I _{MPP} | 7.1 A | 7.1 A | 0.0% |
| R _{S} | 0.8 ohm | 0.8 ohm | 2.8% |
| R _{SH} | 240.3 ohm | 203.9 ohm | -15.2% |

When PV panels using strings constructed similar to string 600 (FIG. 10) were subjected to thermal cycling tests, the results were not ideal. After 128 thermal cycles, the module's maximum power output had fallen more than 15%. This is again believed to be due at least in part to the characteristics of the adhesive tape used to hold the shingled PV cell segments together and/or the configuration of placement of the adhesive strips.

In further tests, PV panels were constructed using strings of PV cell segments constructed similar to string 500 (shown in FIGS. 8 and 9), with three strips of adhesive running the entire length of the string. When the panels constructed in this configuration were subjected to thermal cycle testing, there was negligible maximum power loss after 525 cycles.

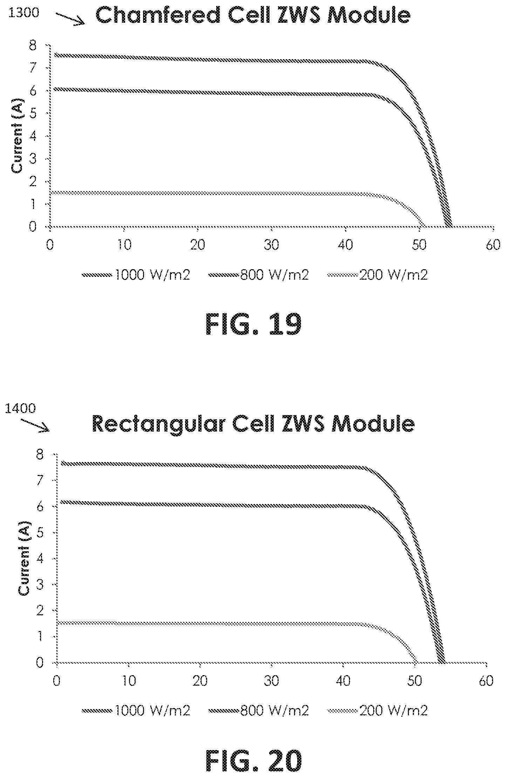

FIG. 19 is a graph 1300 of output current (in amps) as a function of irradiance for a PV module constructed as describe herein using chamfered PV cell segments. FIG. 20 is a graph 1400 of output current (in amps) as a function of irradiance for PV module constructed as describe herein using rectangular PV cell segments. Table 2 presents additional data from the test.

**Table 2**

| | **Chamfered Cell Module** | | | **Rectangular Cell Module** | | |
|---|---|---|---|---|---|---|
| | **1000 W/m2** | **800W/m2** | **200 W/m2** | **1000 W/m2** | **800W/m2** | **200 W/m2** |
| Voc (V) | 54.27 | 53.81 | 50.66 | 54.06 | 53.58 | 50.31 |
| Vmp (V) | 44.87 | 44.75 | 43.62 | 44.29 | 44.17 | 42.82 |
| Isc (A) | 7.60 | 6.07 | 1.52 | 7.69 | 6.17 | 1.53 |
| Imp (A) | 7.12 | 5.71 | 1.40 | 7.31 | 5.87 | 1.45 |
| FF | 0.77 | 0.78 | 0.80 | 0.78 | 0.78 | 0.81 |
| Pmax (W) | 319.33 | 255.57 | 61.17 | 323.66 | 259.39 | 62.23 |

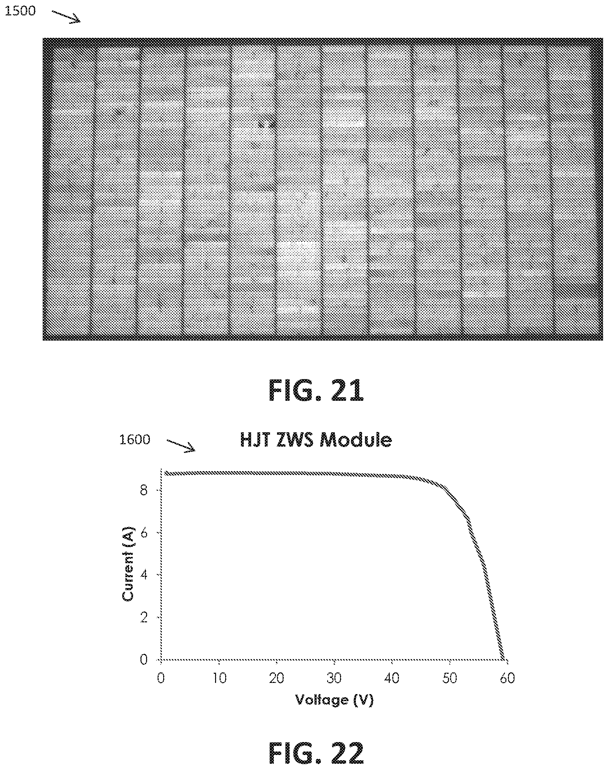

The test panels described above were constructed with PV cell segments made from passive emitter rear contact (PERC) cells. Test panels were also constructed using heterojunction technology (HJT) cells. An EL image of an HJT based test panel 1500 is shown in FIG. 21 and a graph 1600 of the IV curve for the panel is shown in FIG. 22. Table 3 lists additional measured characteristics of the panel.

**Table 3**

| **Parameter** | **Value** |
|---|---|
| Voc (V) | 59.235 |
| Vmp (V) | 48.563 |
| Isc (A) | 8.809 |
| Imp (A) | 8.187 |
| FF (%) | 76.19 |
| Pmax (W) | 397.56 |
| Effi. (%) | 19.62% |

The techniques described herein may be used to produce flexible PV panels. The electrical connection between front and rear electrodes of shingled PV cell segments in strings of PV cell segments without ECA are more mechanically compliant than the connections in some known systems. Once ECA has been cured, it is fairly rigid and inflexible. As a panel of shingled PV cell segments constructed with ECA bends, such as when a heavy load is applied to the middle of the panel, electrical contact between adjacent PV cell segments is often partially or completely compromised. In panels built according to this disclosure without ECA, the adjacent PV cell segments have a greater range of motion relative to each other before the electrical connection is compromised.

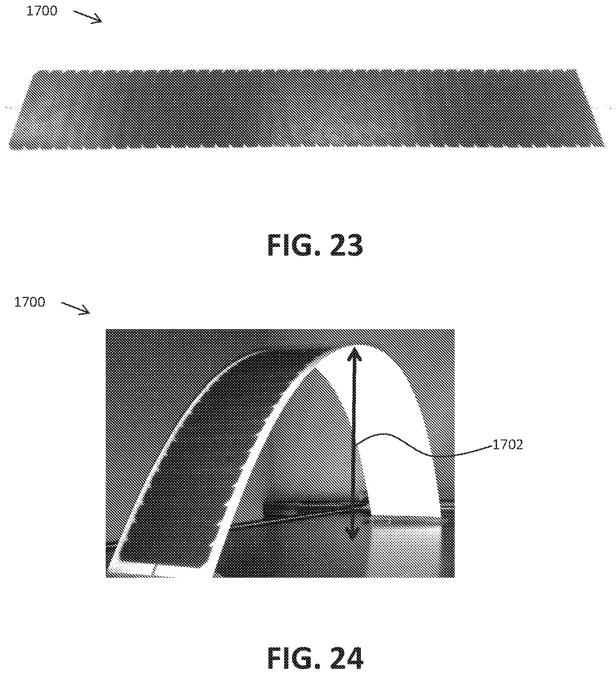

FIG. 23 is a flexible PV laminate 1700 constructed with forty-one PV cell segments shingled together without ECA between electrodes using strings of PV cell segments constructed similar to string 500 (shown in FIGS. 8 and 9). The PV cell segments used in laminate 1700 were 1/6^{th} size (i.e., 1/6^{th} of a standard PV cell) PV cell segments that were shingled into a string with a 1.5 mm overlap. The string was laminated with a flexible, insulating film rather than glass. Any suitable insulating film may be used. One suitable film is InsulPatch® film, available from Madico PhotoVoltaic Backsheets of Woburn, MA.

In FIG. 23, the laminate 1700 is deflected into an arcuate shape without any observable breaking of PV cell segments or loss of electrical contact between PV cell segments. The amount of deflection 1702 of the laminate is about 330 mm. FIG. 24 is an EL image of the deflected laminate, confirming no loss of electrical continuity at this relatively extreme amount of deflection.

The PV modules described herein leverages the electrodes (i.e., busbars) on PV cell segments to directly make contact with each other. There is no ECA or solder between the electrodes of adjacent cell segments holding them together. For the purpose of layup, several cells are laid up with the desired overlap and held together using an insulating adhesive tape. To maintain electrical contact between adjacent cells of a shingled array, sufficient compressive forces are applied by means of lamination between polymer layers. To avoid lateral shear and separation of cells, a combination of frictional forces between cells and adhesive strength of insulating tape are used.

PV modules with directly contacting electrodes (i.e., without ECA) between shingled cells provide numerous advantages over PV modules that include ECA between electrodes of shingled cells.

The absence of ECA reduces the material costs of producing a module. Depending the on module output and cost structure of different materials, the overall cost advantage could be $0.01 - $0.1 per watt. Typically, ECA contains highly conductive silver (Ag) particles. Depending on cell design and process conditions, 1-30 mg of ECA is required between cells. The costs can be prohibitively high. Additionally, ECA is typically stored frozen and requires personnel and equipment to freeze, thaw, and recycle the ECA, which adds to the cost of module production. Because ECA is not used to bond the electrodes of adjacent PV cell segments (which need a certain width for proper adhesion to ECA), the width of the electrodes on the segments of the modules described herein may be reduced, which reduces the amount of material (typically silver) needed to produce the electrodes. The techniques described herein can reduce the amount of silver used for cell electrodes to zero, resulting in significant cost savings while enhancing cell performance.

In the absence of foreign materials (e.g., ECA) between shingled cells, the materials making intimate contact (i.e. the front and rear electrodes) are the same type of material. As a result, mismatch in the coefficients of thermal expansion (CTE) of different materials is non-existent. CTE mismatch is a problem that is known to facilitate and worsen cracks in solar cells over time.

PV modules made according to this disclosure have lower effective resistance than known modules. As described above, in shingled solar array designs with ECA, the effective resistance between two cells is the sum of contact resistance values due to two interfaces with the ECA, as well as the bulk resistance of the ECA. Modules produced according to this disclosure do not include ECA between electrodes. The effective resistance between two cell segments without ECA is simply the contact resistance between the two electrodes. The contacting surfaces are generally made of the same metal (typically silver) which often reduces the series resistance of the solar module.

Modules of embodiments of this disclosure have a lower likelihood of shunting cells than modules that use ECA between cell segments. Conductive adhesives, if not dispensed carefully, can create shunts that can result in significant loss of array power. In the absence of such materials, the risk of shunting cells is almost completely eliminated.

Modules without ECA between the electrodes of shingled PV cell segments can have a smaller overlap, thereby reducing shading and improving the overall efficiency of the module. In known modules with ECA, the minimum permissible overlap between two shingled cells depends on the viscosity of the bonding material. The spread coverage of the adhesive dictates the minimum value of cell overlap. By eliminating ECA, the constraint on cell overlap is significantly reduced. Further, by reducing overlap, it is possible to ensure that the active area in a solar module remains the same while reducing the number of cells used. This results in significant reduction of CTM losses while also saving on the cost of solar cells. For example, if eighty-two PV cells are shingled with a 1.5 mm overlap in a PV module, the module will produce more than twelve watts less power than the same 82 cells in a non-overlapped module. If the overlap is reduced to 0.9 mm, a module with 80 cells produces 0.08 W less power than the 82 cell non-overlapped module. If the overlap is further reduced to 0.2 mm, a module with 78 overlapped cells produces 9.48 W more than the 82 cell non-overlapped module.

Modules with PV cell segments in direct contact without ECA are subjected to less stress during manufacture and may be more reliable. Manufacturing strings with ECA requires a heat source to cure the ECA. The source is typically a thermal mass maintained between 100°C and 200°C. Curing the ECA with this thermal mass places extra thermal cycle stresses on the PV cells, which can lead to premature failure of the PV module with ECA. Moreover, the equipment used for curing the ECA and the electricity needed to operate the equipment adds to the cost of producing a PV module with ECA between cells.

Modules produced with the techniques described herein are more flexible and tolerant than known modules produced with ECA. This allows the modules to have thinner frames, allows thinner laminates to be constructed, allows strings to run along the length of them module, and allows for the production of flexible PV panels.

The techniques described herein also permit in-line inspection/metrology of solar cell strings that is not available in strings made with ECA between PV cell segments. Strings made using foreign material to make electrical contact between cell segments cannot be tested until the foreign material is fully cured and bonded to cells. At that time, if there is a bad connection or a bad cell segment, significant effort is needed to remove the bonded, defective cell segment. The strings produced as described herein permit in-line testing/metrology throughout the assembly process. It is possible to accept/reject individual PV cell segments as the strings are constructed, without requiring any significant rework. This can drastically improve the yield and quality of production facilities.

When introducing elements of the present invention or the embodiment(s) thereof, the articles "a", "an", "the" and "said" are intended to mean that there are one or more of the elements. The terms "comprising", "including" and "having" are intended to be inclusive and mean that there may be additional elements other than the listed elements.

Approximating language, as used herein throughout the specification and claims, may be applied to modify any quantitative representation that could permissibly vary without resulting in a change in the basic function to which it is related. Accordingly, a value modified by a term or terms, such as "about," "approximately," and "substantially," is not to be limited to the precise value specified. In at least some instances, the approximating language may correspond to the precision of an instrument for measuring the value. Here and throughout the specification and claims, range limitations may be combined and/or interchanged; such ranges are identified and include all the sub-ranges contained therein unless context or language indicates otherwise.

## Claims

1. A photovoltaic (PV) module (100) comprising:
a front layer;
a rear layer;
a string (300) of series connected PV cell segments (208) laminated between the front layer and the rear layer, wherein:
each PV cell segment has a front surface including a front electrode (202) and a rear surface including a rear electrode (400);
adjacent PV cell segments (402, 404) are overlapped by an overlap amount (408) with the front electrode of one of the adjacent PV cell segments disposed under and directly contacting the rear electrode of the other of the adjacent PV cell segments, without foreign material therebetween, such as electrically conductive adhesive;
and at least one adhesive strip (406) is attached to the bottom surfaces of a pair of adjacent PV cell segments.

2. The PV module of claim 1, wherein the at least one adhesive strip extends along a length of the string and is attached to the bottom surfaces of all of the PV cell segments in the string.

3. The PV module of claim 2, wherein the at least one adhesive strip is three adhesive strips.

4. The PV module of claim 1, wherein the at least one adhesive strip does not extend beyond the pair of adjacent PV cell segments to which it is attached.

5. The PV module of claim 4, wherein each pair of adjacent PV cell segments has at least one adhesive strip attached to its bottom surfaces.

6. The PV module of claim 4 or 5, wherein the at least one adhesive strip is two adhesive strips.

7. The PV module of any one of claims 1 to 6, wherein the at least one adhesive strip comprises a polyimide film with a silicon adhesive.

8. The PV module of any one of claims 1 to 6, wherein the at least one adhesive strip comprises an insulating tape.

9. The PV module of any one of claims 1 to 8, wherein the overlap amount is less than 1.5 mm, preferably less than 1.0 mm, more preferably 0.9 mm, more preferably less than 0.5 mm, even more preferably 0.2 mm or 0.1 mm.

10. A method of making a photovoltaic (PV) string of PV cell segments, each PV cell segment having a front surface with a front electrode and a rear surface with a rear electrode, the method comprising:
positioning a first PV cell segment;
positioning a second PV cell segment overlapping a portion of the first PV cell segment, the second PV cell segment positioned such that the front electrode of one of the first and second PV cell segments directly contacts the rear electrode of the other of the first and second PV cell segments, without foreign material therebetween, such as electrically conductive adhesive;
applying a first adhesive strip across the rear surfaces of the first and second PV cell segments, and
positioning a third PV cell segment overlapping a portion of the second PV cell segment, the third PV cell segment positioned such that the front electrode of one of the second and third PV cell segments is in direct contact with the rear electrode of the other of the second and third PV cell segments.

11. The method of claim 10, wherein the third PV cell segment is positioned before applying the adhesive strip, and wherein applying a first adhesive strip across the rear surface of the first and second PV cell segments comprises applying a first adhesive strip extending across the rear surface of the first, second, and third PV cell segments.

12. The method of claim 11, further comprising applying at least a second adhesive strip across the rear surface of the first, second, and third PV cell segments.

13. The method of claim 10, further comprising applying a second adhesive strip across the rear surface of the second and third PV cell segments, wherein the first adhesive strip does not extend to the rear surface of the third PV cell segment.

14. The method of any one of claims 10 to 13, further comprising testing the one or more of the first PV cell segment, the second PV cell segment, and the string of PV cell segments,
wherein testing comprises at least one of measuring an open circuit voltage (Voc), a short circuit current (Isc), a maximum power current (Imp), a maximum power voltage (Vmp), a fill factor (FF), a series resistance (Rs), a shunt resistance (Rsh), a power output, and an efficiency, and wherein testing preferably comprises electroluminescent (EL) imaging of the string of PV cell segments.

15. The method of claim 14, wherein the testing is performed before applying the first adhesive strip.

## Patentansprüche

1. Ein Photovoltaik(PV)-Modul (100) umfassend:
eine Frontschicht;
eine Rückenschicht;
eine Kette (300) aus in Serie geschalteten PV-Zellsegmenten (208), die zwischen die Frontschicht und die Rückenschicht laminiert sind, wobei:
jedes PV-Zellsegment eine Frontoberfläche hat, die eine Frontelektrode (202) umfasst, und eine Rückenoberfläche, die eine hintere Elektrode (400) umfasst;
nebeneinanderliegende PV-Zellsegmente (402, 404) überlappen mit einem Grad der Überlappung (408), wobei die Frontelektrode von einem der nebeneinanderliegenden PV-Zellsegmente sich unter und in direktem Kontakt mit der hinteren Elektrode des anderen der nebeneinanderliegenden PV-Zellsegmente, ohne dass sich weiteres Material wie etwas elektrisch leitfähiger Kleber dazwischen befindet;
und wenigstens ein Klebestreifen (406) angebracht ist auf den Bodenoberflächen eines Paars von nebeneinanderliegenden PV-Zellsegmenten.

2. Das PV-Modul gemäß Anspruch 1, worin sich der wenigstens eine Klebestreifen entlang der Kette erstreckt und an den Bodenoberflächen von allen PV-Zellsegmenten in der Kette angebracht ist.

3. Das PV-Modul gemäß Anspruch 2, worin der wenigstens eine Klebestreifen drei Klebestreifen ist.

4. Das PV-Modul gemäß Anspruch 1, worin sich der wenigstens eine Klebestreifen nicht über das Paar von nebeneinanderliegenden PV-Zellsegmenten hinaus erstreckt, an das es angebracht ist.

5. Das PV-Modul gemäß Anspruch 4, worin jedes Paar von nebeneinanderliegenden PV-Zellsegmenten wenigstens einen Klebestreifen aufweist, der auf seinen Bodenoberflächen angebracht ist.

6. Das PV-Modul gemäß Anspruch 4 oder 5, worin der wenigstens eine Klebestreifen zwei Klebestreifen ist.

7. Das PV-Modul gemäß irgendeinem der Ansprüche 1 bis 6, worin der wenigstens eine Klebestreifen einen Polyimidfilm mit einem Silikonkleber umfasst.

8. Das PV-Modul gemäß irgendeinem der Ansprüche 1 bis 6, worin der wenigstens eine Klebestreifen ein isolierendes Tape umfasst.

9. Das PV-Modul gemäß irgendeinem der Ansprüche 1 bis 8, worin der Grad der Überlappung weniger als 1,5 mm, bevorzugt weniger als 1,0 mm, noch bevorzugter 0,9 mm, noch bevorzugter weniger als 0,5 mm, sogar noch bevorzugter 0,2 mm oder 0,1 mm beträgt.

10. Ein Verfahren zur Herstellung einer Photovoltaik(PV)-Kette aus PV-Zellsegmenten, wobei jedes PV-Zellsegment eine Vorderseitenoberfläche mit einer Frontelektrode und eine Rückseitenoberfläche mit einer hinteren Elektrode hat, das Verfahren umfassend:
Positionieren eines ersten PV-Zellsegments;
Positionieren eines zweiten PV-Zellsegments, so dass es einen Teil des ersten PV-Zellsegments überlappt, wobei das zweite PV-Zellsegment so positioniert wird, dass die Frontelektrode von einem aus erstem und zweitem PV-Zellsegment die hintere Elektrode des anderen aus erstem und zweitem PV-Zellsegment direkt kontaktiert, ohne dass sich weiteres Material wie etwas elektrisch leitfähiger Kleber dazwischen befindet;
Anbringen eines ersten Klebestreifens quer über die Rückenoberflächen der ersten und zweiten PV-Zellsegmente, und
Positionieren eines dritten PV-Zellsegments, so dass es einen Teil des zweiten PV-Zellsegments überlappt, wobei das dritte PV-Zellsegment so positioniert wird, dass die Frontelektrode von einem aus zweitem und drittem PV-Zellsegment die hintere Elektrode des anderen aus zweitem und drittem PV-Zellsegment direkt kontaktiert.

11. Das Verfahren gemäß Anspruch 10, worin das dritte PV-Zellsegment positioniert wird bevor der Klebestreifen angebracht wird, und worin das Anbringen eines ersten Klebestreifens quer über die Rückenoberflächen des ersten und zweiten PV-Zellsegments das Anbringen eines ersten Klebestreifens umfasst, der sich quer über die Rückenoberfläche des ersten, zweiten und dritten PV-Zellsegments erstreckt.

12. Das Verfahren gemäß Anspruch 11, des Weiteren umfassend das Anbringen wenigstens eines zweiten Klebestreifens quer über die Rückenoberfläche des ersten, zweiten und dritten PV-Zellsegments.

13. Das Verfahren gemäß Anspruch 10, des Weiteren umfassend das Anbringen eines zweiten Klebestreifens quer über die Rückenoberfläche des zweiten und dritten PV-Zellsegments, wobei sich der erste Klebestreifen nicht bis zur Rückenoberfläche des dritten PV-Zellsegments erstreckt.

14. Das Verfahren gemäß irgendeinem der Ansprüche 10 bis 13, des Weiteren umfassend einen Test von einem oder mehreren aus erstem PV-Zellsegment, zweitem PV-Zellsegment und PV-Zellsegment-Kette,
wobei der Test umfasst wenigstens eine Messung ausgewählt aus Messung einer Leerlaufspannung (Voc), eines Kurzschlussstroms (Isc), einer Grenzstromstärke (Imp), einer Höchstspannung (Vmp), eines Füllfaktors (FF), eines Reihenwiderstands (Rs), eines Ableitwiderstands (Rsh), Ausgangsleistung, und Effizienz, und wobei der Test bevorzugt umfasst die Elektrolumineszenz(EL)-Abbildung der Kette aus PV-Zellsegmenten.

15. Das Verfahren gemäß Anspruch 14, worin der Test vor dem Anbringen des ersten Klebestreifens durchgeführt wird.

## Revendications

1. Un module photovoltaïque (PV) (100) comprenant :
une couche frontale ;
une couche arrière ;
une chaîne (300) de segments de cellules PV (208) connectés en série stratifiés entre la couche frontale et la couche arrière, dans lequel :
chaque segment de cellule PV a une surface frontale comprenant une électrode frontale (202) et une surface arrière comprenant une électrode arrière (400) ;
des segments de cellules PV (402, 404) adjacents sont en chevauchement sur un degré de chevauchement (408) avec l'électrode frontale de l'un des segments de cellules PV adjacents disposée sous l'électrode arrière de l'autre des segments de cellules PV adjacents et en contact direct avec celle-ci, sans matériau étranger placé entre eux, tel qu'un adhésif électriquement conducteur ;
et
au moins une bande adhésive (406) est fixée sur les surfaces inférieures d'une paire de segments de cellules PV adjacents.

2. Le module PV selon la revendication 1, dans lequel ladite au moins une bande adhésive s'étend sur une longueur de la chaîne et est fixée sur les surfaces inférieures de tous les segments de cellules PV dans la chaîne.

3. Le module PV selon la revendication 2, dans lequel ladite au moins une bande adhésive est constituée de trois bandes adhésives.

4. Le module PV selon la revendication 1, dans lequel ladite au moins une bande adhésive ne s'étend pas au-delà de la paire de segments de cellules PV adjacents à laquelle elle est fixée.

5. Le module PV selon la revendication 4, dans lequel chaque paire de segments de cellules PV adjacents comporte au moins une bande adhésive fixée sur ses surfaces inférieures.

6. Le module PV selon la revendication 4 ou la revendication 5, dans lequel ladite au moins une bande adhésive est constituée de deux bandes adhésives.

7. Le module PV selon l'une quelconque des revendications 1 à 6, dans lequel ladite au moins une bande adhésive comprend un film de polyimide avec un adhésif au silicium.

8. Le module PV selon l'une quelconque des revendications 1 à 6, **caractérisé en ce que** ladite au moins une bande adhésive comprend un ruban isolant.

9. Le module PV selon l'une quelconque des revendications 1 à 8, dans lequel le degré de chevauchement est inférieur à 1,5 mm, de préférence inférieur à 1,0 mm, de préférence inférieur à 0,9 mm, de préférence inférieur à 0,5 mm, de manière encore préférée inférieur à 0,2 mm ou 0,1 mm.

10. Un procédé de fabrication d'une chaîne photovoltaïque (PV) de segments de cellules PV, chaque segment de cellule PV ayant une surface frontale avec une électrode frontale et une surface arrière avec une électrode arrière, le procédé comprenant :
le fait de positionner un premier segment de cellule PV ;
le fait de positionner un deuxième segment de cellule PV chevauchant une partie du premier segment de cellule PV, le deuxième segment de cellule PV étant positionné de telle sorte que l'électrode frontale de l'un des premier et deuxième segments de cellules PV est en contact direct avec l'électrode arrière de l'autre des premier et deuxième segments de cellules PV, sans matériau étranger placé entre eux, tel qu'un adhésif électriquement conducteur ;
le fait d'appliquer une première bande adhésive sur les surfaces arrière des premier et deuxième segments de cellules PV, et
le fait de positionner un troisième segment de cellule PV chevauchant une partie du deuxième segment de cellule PV, le troisième segment de cellule PV étant positionné de telle sorte que l'électrode frontale de l'un des deuxième et troisième segments de cellules PV soit en contact direct avec l'électrode arrière de l'autre des deuxième et troisième segments de cellules PV.

11. Le procédé selon la revendication 10, dans lequel le troisième segment de cellule PV est positionné avant le fait d'appliquer la bande adhésive, et dans lequel le fait d'appliquer une première bande adhésive sur la surface arrière des premier et deuxième segments de cellules PV comprend le fait d'appliquer une première bande adhésive s'étendant sur la surface arrière des premier, deuxième, et troisième segments de cellules PV.

12. Le procédé selon la revendication 11, comprenant en outre le fait d'appliquer au moins une deuxième bande adhésive sur la surface arrière des premier, deuxième et troisième segments de cellules PV.

13. Le procédé selon la revendication 10, comprenant en outre le fait d'appliquer une deuxième bande adhésive sur la surface arrière des deuxième et troisième segments de cellules PV, la première bande adhésive ne s'étendant pas sur la surface arrière du troisième segment de cellule PV.

14. Le procédé selon l'une quelconque des revendications 10 à 13, comprenant en outre le fait de tester lesdits un ou de plusieurs parmi le premier segment de cellule PV, le deuxième segment de cellule PV et la chaîne de segments de cellules PV,
le test comprenant au moins un parmi : le fait de mesurer une tension en circuit ouvert (Voc), un courant de court-circuit (Isc), un courant de puissance maximale (Imp), une tension de puissance maximale (Vmp), un facteur de remplissage (FF), une résistance série (Rs), une résistance shunt (Rsh), une sortie de puissance et une efficacité, et le test comprenant de préférence le fait de prendre une image électroluminescente (EL) de la chaîne de segments de cellules PV.

15. Le procédé selon la revendication 14, dans lequel l'essai est effectué avant l'application de la première bande adhésive.
